# EUROPEAN PATENT APPLICATION

(11) **EP 4 764 821 A1**
(43) Date of publication of application: **24.06.2026**
(21) Application number: 25223942.1
(22) Date of filing: 16.12.2025
(51) Int. Cl.: G06F 7/544, G06F 3/06

(54) **MULTIPLY-ACCUMULATE (MAC) APPARATUS FOR IN-MEMORY COMPUTING**

(30) Priority: 20.12.2024 FI 20246535
(71) Applicant: Nokia Solutions and Networks Oy, 02610 Espoo (FI)
(72) Inventor: JIANG, Zhewei, Oakland Gardens (US); CHOW, Hungkei, Murray Hill (US)
(74) Representative: Nokia EPO representatives

(57) **Abstract**

A capacitive charge-coupling mode analog compute in-memory (CIM) bitcell array is configured to generate an analog output voltage corresponding to a multiply-accumulate (MAC) operation result using a multibit weight. The analog output voltage is inputted to a dual-mode activation module which is selectively operable either in a Deep Neural Network (DNN) mode and a Spiking Neural Network (SNN) mode. The activation module comprises a sample and hold (S&H) circuit, a comparator, a digital-to-analog converter (DAC) which can be reconfigured in accordance with the selected one of the DNN mode and the SNN mode.

## Description

### TECHNICAL FIELD

Example embodiments relate to In-Memory Computing (IMC) and, more specifically, an In-Memory Computing apparatus configured to perform a multiply-accumulate (MAC) operation.

### BACKGROUND

Integrated Circuits (ICs) are widespread in modern electronics and may be used to implement a wide range of processing and memory devices. In-memory computing technology is a developing area which aims to provide improvements in computational performance. Traditional systems tend to store data in memory that is separate from the processor which performs tasks such as arithmetic and logic functions. With the increase in data required for certain applications, such as with neural network processing, data movement between the processor and memory may present one of the more critical performance and energy bottlenecks. In-memory computing can improve processing performance through the use of memory technologies that are also able to perform certain computational tasks such as the arithmetic and/or logical functions.

### SUMMARY

The scope of protection sought for various example embodiments is set out by the claims. The example embodiments and features, if any, described in this specification that do not fall under the scope of the claims are to be interpreted as examples useful for understanding various embodiments.

According to a first aspect, there is provided an apparatus, comprising:
a bit-cell array configured to generate an analog output corresponding to a multiply-accumulate (MAC) operation result using a multibit weight and a multibit input in charge domain, wherein the bitcell array comprises a plurality of bitcells connected to corresponding column bitlines via capacitive coupling, and wherein each column bitline is connected to a capacitor ladder to produce an analog output voltage that represents a combined MAC operation result of all column bitlines,
a dual-mode activation module which is selectively operable either in a Deep Neural Network (DNN) mode and a Spiking Neural Network (SNN) mode, comprising
   - a sample-and-hold circuit configured to sample the analog output voltage received from the capacitor ladder to an input and hold the analog output voltage sample at an output, the sample and hold circuit comprising a first reconfigurable capacitor bank, a second reconfigurable capacitor bank, and control switch elements for selectively coupling the first reconfigurable capacitor bank and the second reconfigurable capacitor bank to the input or the output,
   - a comparator having a first input to receive the analog output voltage sample, a second input, and a control output,
   - a digital-to-analog converter (DAC) having a digital control input and an analog voltage output connected to the second input of the comparator, and
   - a control circuitry configured to receive a comparison result from the control output of the comparator and configured to control the dual-mode activation module in accordance with the selected one of the DNN mode and the SNN mode.

In an embodiment, in the DNN mode, the sample-and-hold circuit is configured to operate as a ping-pong buffer, the first and second reconfigurable capacitor banks are configured to operate as holding capacitors that are in turn connected to the input and the output.

In an embodiment, in the DNN mode, capacitances of the first and second reconfigurable capacitor banks are configured to be equal with a total capacitance of the capacitor ladder of the bitcell array.

In an embodiment, in the DNN mode, the comparator and the DAC are configured to operate as a successive approximation register (SAR) Analog-to-Digital converter (ADC) converting the output voltage sample into a digital output value.

In an embodiment, in the SNN mode, the sample-and-hold circuit is configured to operate as a leakage-and-charge pump accumulator, the second reconfigurable capacitor bank is con-figured to form a stacked charge pump, and the first reconfigurable capacitor bank is configured to discharge the stacked charge pump by an amount that rep-resents a preset leakage rate.

In an embodiment, in the SNN mode, the comparator is configured to operate as a thresholding circuit for firing a spike.

In an embodiment, in the SNN mode, the DAC is configured to create an analog threshold voltage to the second input of the comparator.

In an embodiment, in the SNN mode, the second reconfigurable capacitor bank is configured to sample the analog output voltage in one capacitor of the second reconfigurable capacitor bank at time in a certain order, wherein the sampled voltage of each capacitor of the second reconfigurable capacitor bank is then stacked with previously sampled voltage of previous capacitors, if any, to perform accumulation and provide an accumulated voltage, with the first reconfigurable capacitor bank acting as leakage, until a time reset or until the comparator determines that the accumulated voltage exceeds a threshold voltage.

In an embodiment, in the SNN mode, an alternating one of two preset capacitors of the second reconfigurable capacitor bank is selected as a first capacitor in order to sample the analog output voltage so as and to hereby provide a ping-pong buffering for the two preset capacitors after a time reset or firing a spike

In an embodiment, the first reconfigurable capacitor bank comprises a ratioed capacitor bank or a C-2C capacitor ladder.

In an embodiment, the second reconfigurable capacitor bank comprises a plurality of capacitors with equal capacitances.

In an embodiment, each capacitor in the first reconfigurable capacitor bank and in the second reconfigurable capacitor bank is individually connectable to and disconnectable from the respective capacitor bank to reconfigure the respective capacitor bank.

In an embodiment, capacitors in the second reconfigurable capacitor bank are selectively connectable in series, in parallel, and connectable to and disconnectable from the second reconfigurable capacitor bank.

In an embodiment, in the DNN mode, the first and second reconfigurable capacitor banks are configured to operate as holding capacitors each having a capacitance equal to a capacitance of the capacitor ladder.

In an embodiment, in the SNN mode, the sample-and-hold circuit is configured to sequentially, one by one, charge the capacitors in the second reconfigurable capacitor bank by the output voltage and connect the charged capacitance units in series to sequentially grow the stacked charge pump until a stacked voltage of the stacked charge pump exceeds a threshold voltage or a preset period of time expires.

In an embodiment, in the SNN mode, the control circuitry is configured to fire a spike responsive to the comparator determining that a threshold voltage is exceeded.

In an embodiment, in the SNN mode, the control circuitry is configured to reset the first and second reconfigurable capacitor banks and to restart the sequential charging of the stacked charge pump after firing a spike or after a preset period of time.

In an embodiment, in the SNN mode, the first reconfigurable capacitor bank is configured to discharge the stacked charge pump at a preset leakage rate or a sequence of preset leakage rates.

### BRIEF DESCRIPTION OF THE DRAWINGS

Some example embodiments will now be described with reference to the accompanying drawings, in which
Figure 1 is a diagram showing an exemplary artificial neural network (ANN);
Figure 2 is a diagram illustrating an exemplary operation of a spiking neuron in a spiking neural network (SNN);
Figure 3 is a block diagram of an exemplary compute-in-memory (CIM) module for performing a multiple-and-accumulate operation in accordance with some example embodiments;
Figure 4 is a block diagram illustrating an example of one bitcell array region of a CIM module for performing a multiple-and-accumulate operation in accordance with some example embodiments;
Figure 5 is a block diagram of an exemplary activation module supporting both DNN and SNN operation in accordance with some example embodiments;
Figure 6 is a more detailed block diagram of an exemplary activation module 300 supporting both DNN and SNN operation in accordance with some example embodiments;
Figure 7 is a circuit diagram of an exemplary reconfigurable capacitor bank A in accordance with some example embodiments;
Fig. 8 is a circuit diagram of an exemplary reconfigurable capacitor bank B in accordance with some example embodiments;
Figures 9 and 10 are circuit diagrams illustrating exemplary DNN configurations of the capacitor banks A and B, respectively, in accordance with some example embodiments;
Figure 11 is a diagram that illustrates an example of 8 cycles ping-pong pipelining in DNN mode in accordance with some example embodiments;
Figure 12A is a block diagram that illustrates an example in which 4 rows with 8-bit weights in one bitcell column receive spike trains of 4 time steps;
Figure 12B shows the exemplary digital values mathematically computed by the bitcell array using spike trains and weights shown in Figure 12A;
Figure 12C illustrates an example of an actual analog voltage waveform from the bitcell array;
Figure 12D illustrates the exemplary relationship between the digital values and the analog voltage waveform:
Figure 13 shows an example of the capacitor bank A configured to provide a preset leakage rate in accordance with embodiments;
Figure 14 is a block diagram illustrating three exemplary phases between which the S&H circuit may change during n cycles input repetition in accordance with embodiments:
Figure 15 is a state diagram that illustrates an example of possible state transitions during a 4-cycle iteration; and
Figures. 16A, 16B, 16C, 16D, 16E, 16F, 16G, 16H, and 16I show exemplary circuit diagrams the switch states to the switching bridge and the capacitor bank B and the related voltages during a 4-cycle iteration.

### DETAILED DESCRIPTION

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments within the scope of the claims. Furthermore, the words "comprising" and "including" should be understood as not limiting the described embodiments to consist of only those features that have been mentioned, and such embodiments may also contain features that have not been specifically mentioned. Reference numbers, in the description and/or in the claims, serve to illustrate the embodiments with reference to the drawings, without limiting the embodiments to these examples only.

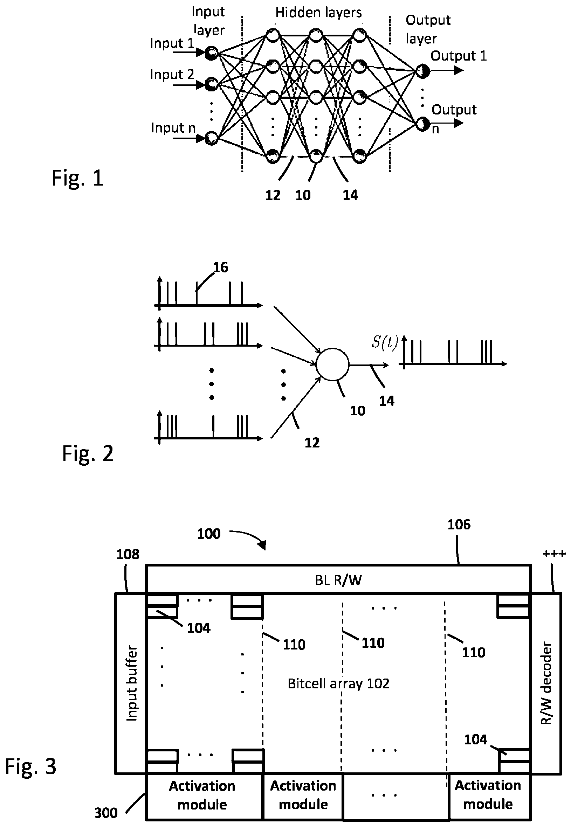

A neural network is a group of interconnected units called neurons that send signals to one another. An artificial neural network consists of simulated neurons, i.e. artificial neurons. Each artificial neuron has inputs and produces a single output which can be sent to multiple other neurons. Neurons in an Artificial Neural Network (ANN) are usually arranged into layers, with information passing from the first layer (the input layer) through one or more intermediate layers (the hidden layers) to the final layer (the output layer), as illustrated schematically by an exemplary ANN shown in Fig. 1. A network is typically called a Deep Neural Network (DNN) if it has at least two hidden layers. The "signal" input to each neuron (e.g., neuron 10 in Fig. 1) is a number, e.g., a linear combination of the outputs of the connected neurons in the previous layer. The signal each neuron outputs is computed by some non-linear function of the sum of its inputs, called the activation function. In a DNN, each connection (e.g., a connection 12 to or a connection 14 from the neuron 10 in Fig. 1) between neurons in adjacent layers is associated with a weight. Weights are numerical values that represent the strength of the neuron's connection and determine how much influence the output of one neuron has on the input of another. Behaviour of the network depends on the strengths (or weights) of the connections between neurons. When a DNN is still untrained, the weights are assigned random values. During training, the deep neural network adjusts weights iteratively in response to the difference between the expected and actual output.

A convolutional neural network (CNN) is a DNN primarily used for artificial intelligence (AI) and machine learning (ML) applications. In computer systems, convolution is a mathematical operation between two matrices often referred as an input window and a filter. For example, given a 10x10 matrix (the input window) and a 3x3 matrix (the filter), the process is to multiply the input window and the filter for each possible combination of positions as you superimpose the filter matrix over the input matrix. This can be accomplished by overlaying the filter at the first position, multiplying the over-lapping values and adding them together to get the output, referred to herein as a dot product or partial sum. Next, the filter is shifted one or more column/row over and the same calculations are repeated. Once at the end of the row/column, the filter is shifted one or more row/column and the process repeated. This continues until the end of the input matrix is reached.

The multiply-accumulate (MAC) operation is a building block of a variety of computational processes used in neural networks. For example, the convolution function, also sometimes referred to as cross-correlation or sliding dot product, is produced by determining the integral of the product of the two functions for all possible values of shift. The efficiency of performing the multiple-accumulate operation often determines the overall performance of a hardware accelerator design. Some digital designs use an SRAM to store the matrix operands and digital logic to perform arithmetic operations. In such designs, the memory access presents a major bottleneck and often dominates power consumption. Computing-in-Memory (CIM), also sometimes referred to as In-Memory Computing (IMC) or Processing-in-Memory (PIM), perform the MAC operation in the memory itself. In other words, SRAM based CIM circuits can use a dense array of SRAM-based bit cells, to perform a massive number of multiplication and summation operations simultaneously in mixed digital and analog domain. Performing computational operations at the memory cell removes the memory access bottleneck and greatly reduces the power consumption of accessing data. Accordingly, CIM circuits can offer orders of magnitude higher computational throughput and energy efficiency as compared to digital logic designs. The computation performed by mixed signal circuits also presents a significant power and area saving.

To achieve high efficiency while keeping a relatively high computational precision, EP4086910A1 presents a capacitive charge-coupling mode analog CIM design for DNN implementation. Inputs are applied to the macro bit-serially whereas the weight bits are distributed across multiple columns of memory bitcells. The bitcells perform a binary multiplication in the digital domain, and the result determines the state of an output capacitor (charged or depleted). The output capacitors for a column of bitcells determine the charge stored to a holding capacitor for that column. The holding capacitors for adjacent bitcell columns form a capacitive voltage divider, resulting in an analog voltage that represents the MAC result. Sample-and-hold (S&H) circuit accumulates over multiple input cycles, representing the sum of each binary MAC result, accounting for the input bit significance. The capacitive voltage dividers form a C-2C ladder, which accumulate these charges over the columns to represent the final MAC results, which are summations of the partial results for each bit of the weights. The final analog voltage may then be digitized using a successive approximation register (SAR) Analog to Digital converter (ADC).

Despite the great advancement, ANNs/DNNs still lag the biological neural network in terms of energy efficiency and abilities for online learning. Although ANNs/DNNs are historically brain-inspired, their implementations are fundamentally different in structure, computations, and learning rules compared to the biological neural network. The heavy energy consumption of most DNNs is a result from the continual transmission of real-valued activities between connected nodes as well as the subsequent matrix multiplication and convolution in the network.

Many attempts have been made to reduce the power consumption of DNN implementation. This leads to the reappearing of Spiking Neural Networks (SNNs) as a promising alternative to DNNs. In SNNs, neurons communicate with each other with discrete electrical signals called spikes in continuous time. In other words, the information from one neuron 10 is relayed to another neuron in the form of binary-valued spikes 16, as illustrated schematically in Fig. 2. Due to their functional similarity to the biological neural networks, SNNs offer an advantage of the sparsity and are highly compatible with temporal coding. Although SNNs are still behind DNNs in inference accuracy, the gap is narrowing in some tasks, and SNNs typically require much lower energy consumption for their operation.

Until recently, several DNN-to-SNN conversion methods have emerged. They focused on converting ReLU to Integrate-and-Fire neurons, batch normalization and spike max-pooling. As a result, the converted networks can retain the same information transmission and function but significantly decrease the costs of signal transmission and computation. Binary-valued spikes reduce the number of bits per transmission by turning real-valued signals into binary pulses, and they make signals sparse in time by not transmitting information for each connection every timestep.

Early ASIC implementations of realize the core components of SNN using conventional digital circuit techniques. They fall short of showing a significant benefit of energy and area efficiency over conventional DNN implementation. To improve efficiency, most recent designs adopt an analog circuit technique in current-mode computation using memristor or similar devices. While these current-mode designs show significant improvement in energy consumption and area, they exhibit limitations in computational precision (≤ 6 bits) and accuracy. It is because these devices generally have high variability in fabrication process and are very sensitive to temperature variation. These compute-in-memory designs can offer only limited dynamic range and low noise immunity. Current-mode analog CIM designs may prove to be suited for SNN with low precision and accuracy applications, but they are generally insufficient for most DNN implementations. An alternative analog CIM design that can support both DNN and SNN is therefore highly desirable.

While deep SNNs have achieved comparable results to those of original DNNs (e.g., VGG and ResNet), there are still applications that require high inference accuracy that will stay wholly or partially in real-valued DNN form. It is therefore imperative to have a hardware implementation that can support both multi-bit-valued DNNs and binary-valued SNNs at a desirable precision, accuracy and efficiency.

An aspect of the invention is a mixed-signal (hybrid analog/digital) compute-in-memory (CIM) design that can be configured to support both a deep neural network (DNN) and a spiking neural network (SNN) efficiently).

In some example embodiments, a capacitive charge-coupling mode analog compute in-memory (CIM) bitcell array is configured to generate an analog output voltage corresponding to a multiply-accumulate (MAC) operation result using a multibit weight. The analog output voltage is inputted to a dual-mode activation module which is selectively operable either in a Deep Neural Network (DNN) mode and a Spiking Neural Network (SNN) mode. The activation module comprises a sample and hold (S&H) circuit and a converter which can be re-configured to support real-valued input and output signals in the DNN mode as well as binary-valued input and output signals (spikes) in the SNN mode.

In some example embodiments, a capacitive charge-coupling mode analog CIM design of a type presented for DNN implementation in EP4086910A1 or like is adapted to SNN to achieve a novel CIM design that can support both DNN and SNN efficiently. The analog CIM can retain a high computational precision (8/8/8b) and accuracy that are critical for real-valued DNN use cases, but it can also be configured to realize the most widely used SNN models. In some example embodiments, the core components such as Sample-and-Hold (S&H) and Analog-to-Digital Converter (ADC) that are used to support DNN are adapted to be reconfigurable so that they can be reused in SNN acceleration at low overhead. Unique SNN operation, such as leaky-integrate-and-fire (LIF), is added to CIM design with a minimal energy consumption and area penalty.

According to an aspect of the invention, the capacitive charge-coupling mode analog CIM bit-cell array is augmented with a configurable dual-mode activation module.

In some example embodiments, the activation module includes a modified S&H circuit which can be reconfigured to support the original DNN operation as well as a leakage-and-charge pump accumulator operation.

In some example embodiments, the activation module also includes a reconfigurable DAC capacitor bank and comparator that can be used as a successive approximation register (SAR) Analog to Digital converter (ADC) for DNN digitization and as a thresholding circuit for a SNN firing/spiking operation.

In some example embodiments, the activation module also includes a SAR control entity for the DNN operation and a firing control entity for the SNN firing/spiking operation. Depending on the mode of operation, the SAR control entity or a firing entity can be selected to determine the output of a CIM operation.

In some example embodiments, the novel analog CIM design can support both DNN and SNN operation efficiently with a minimal overhead in either mode of operation. It is because many or all core components including a bit-cell array, a capacitor mesh, a S&H circuit, a DAC capacitor bank and a comparator, can be fully utilized in either mode of operation. The two mutually exclusive entities or modules, the SAR-control and the firing-control, are relatively simple controllers that consume relatively small amounts of energy and area. In embodiments, the SAR control entity and the firing control entity are control logic circuits. In some example embodiments, the SAR control entity and the firing control entity are or controllers. In some example embodiments, the SAR control entity and the firing control entity are implemented as software and/or firmware modules in a programmable controller unit.

Some example embodiments of the present techniques provide a MAC accelerator apparatus with charge domain CIM modules. The CIM modules compute in the charge domain, where the inputs are applied to the macro bit-serially whereas the weight bits are distributed across multiple columns of memory bitcells. The bitcells perform a binary multiplication in the digital domain, and the result determines the state of an output capacitor (charged or depleted). The output capacitors for a column of bitcells determine the charge stored for that column in a capacitor mesh or ladder at the end of the column. The capacitive charge-coupling mode analog CIM bit-cell array and the bitcells may be implemented in various ways. For example, the bitcell array and/or the bitcells may be implemented according to embodiments disclosed in EP4086910A1, which is incorporated by a reference in this application.

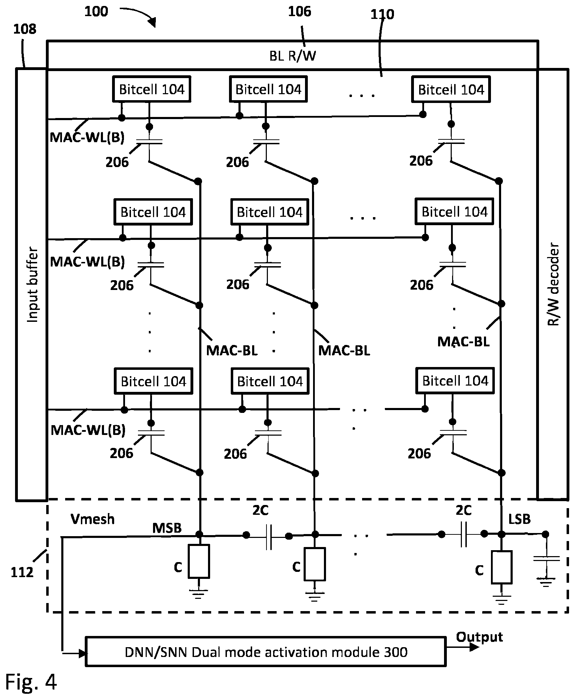

Fig. 3 is a block diagram of an example compute-in-memory (CIM) module for performing a vector-matrix multiplication (VMM) operation in accordance with some example embodiments. The CIM module 100 includes a crossbar bitcell array 102 where each bitcell 104 is formed at an intersection of a row-line and a column-line. The bitcell array stores weight matrix data and also performs bitwise multiplication of each weight and corresponding inputs from an input window. As used herein, the term input or input value is used to refer to the entire N-bit input or the entire spike train, whereas the term input bit or binary state refers to a single bit or a binary state of an input value or a spike train. Similarly, the term weight or weight value is used to refer to the entire N-bit weight, whereas the term weight bit refers to a single bit of the weight value. The state of each bitcell 104 determines whether it represents a value of zero or a value of one. Although only few bitcells 104 are shown, it will be appreciated that the bitcells array 102 can include any suitable number of bitcells, for example, several hundred bitcells. Bitcell states may be set or reset by a bit line Read/Write circuitry 106. As illustrated in the example shown in Fig. 3, the bitcell array 102 may be divided into regions 110, each of which can have a set of columns representing a different filter. Although only few regions 110 are depicted, it will be appreciated that the bitcell array 102 may be divided into any number of regions 110 of the same size. The number of columns in each region 110 depends on the number of bits used to represent filter weights. Fig. 4 is a block diagram illustrating an example of one bitcell array region 110 of a CIM module for performing a multiple-and-accumulate operation in accordance with embodiments.

For purposes of the present description, each filter weight is represented by an 8-bit binary number occupying 8 columns of the bitcell array. Thus, each region 110 would eight columns of bitcells wide. However, the present techniques can be implemented for any suitable bit precision, including 4 bits or others. The weights in one region 110 represent a single filter which has been unrolled from the matrix form into one column. In some example embodiments, the filter may be copied multiple times to the same column to account for multiple channels of input. For example, in a system with a 4-by-4 filter matrix and four input channels, each column with have 64 bitcells (16 weights per filter times 4 channels). In the bitcell array 102, weight bit significance is represented by the position of the bit in the 8-bit region. Each bitcell 104 in the bitcell array 102 is configured to multiply its stored weight bit with a corresponding bit or a binary state (spike) of input received from an input buffer 108 on a corresponding input bitline MAC-WL(B) and to output a zero charge if the result of the multiplication is zero or a non-zero charge if the result of the multiplication is one. All of the outputted charges in a single column are effectively summed in the analog domain through a capacitive coupling with a common capacitor plate. The capacitive coupling may be provided by an output capacitor 206 connected between the output of the bitcell 104 and the corresponding column bitline MAC-WL. Each bitcell column or bitline MAC-BL is connected to a capacitor mesh or ladder 11 at the end of the column. The capacitor mesh or ladder 11 is configured to combine of the MAC operation results of the individual column bitlines MAC-BL and to produce an analog output voltage Vmesh that represents the MAC operation result. The analog output voltage Vmesh can then be sampled and converted into a DNN digital value or into SNN output spikes using a dual-mode activation module 300. In the DNN mode, the capacitor mesh or ladder 11 also provides a binary weighting of the MAC operation results of the column bitlines when producing an analog output voltage Vmesh. In some example embodiments, the capacitor mesh or ladder 11 may be a C-2C ladder, such as that shown in Fig. 4. The C-2C ladder 11 may have an individual holding capacitor C for each column, e.g. as illustrated by example in Fig. 4, or the capacitor C may be implemented by other capacitor configurations, e.g., switched capacitors. In some example embodiments, the capacitor mesh or ladder 11 may be a ratioed capacitor ladder.

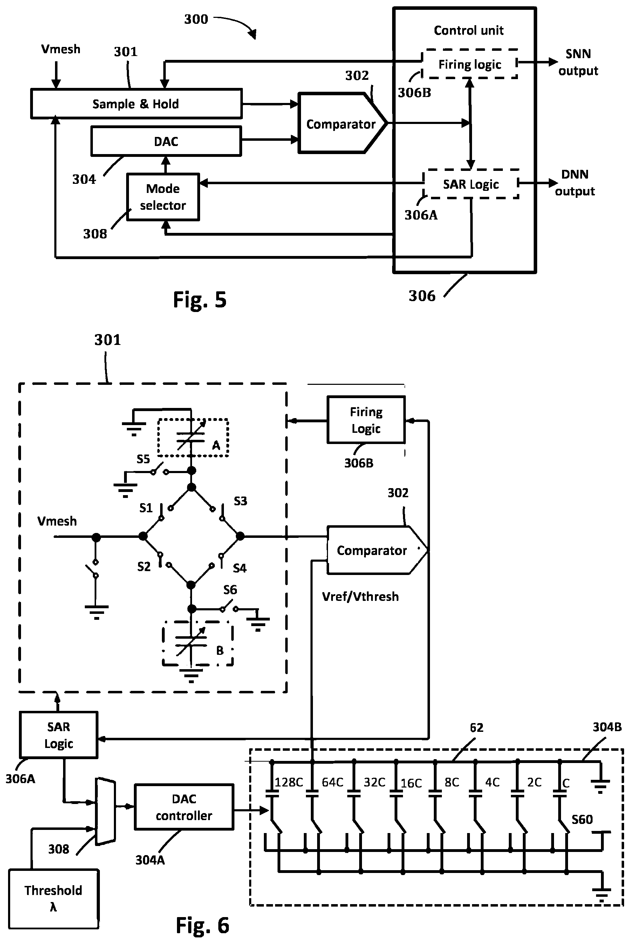

Fig. 5 is a block diagram of an exemplary activation module 300 supporting both DNN and SNN operation according to some example embodiments. The activation module 300 includes a reconfigurable sample and hold (S&H) circuit 301, a comparator 302, a digital-to-analog converter (DAC) 304, and a control unit 306. The S&H circuit 301 receives the output voltage Vmesh from the capacitor mesh or ladder 11 of the bitcell array 102, samples the output voltage and holds the analog output voltage sample at an output. The voltage sample is applied from the output of the S&H circuit to one input of the comparator 302. A reference voltage or a threshold voltage from the DAC 304 is connected to another input of the comparator 302. The comparison result from the comparator 302 is outputted to the control unit 306. The control unit 306 may include a SAR control entity 306A for the DNN operation and a firing control entity 306B for the SNN firing/spiking operation. Depending on the mode of operation, the SAR control entity 306A or the firing control entity 306 can be selected, and the configuration and operation of the S&H circuit 301, the comparator 302, and the DAC 304 can be reconfigured accordingly. In the DNN mode, the S&H circuit 301 is configured to operate as a ping-pong buffer, and the comparator 302 and the DAC 304 are configured to operate as a successive approximation register (SAR) Analog to Digital converter (ADC) converting the output voltage sample into a digital output value (DNN output). In the SNN mode, the S&H circuit 301 is configured to operate as a leakage-and-charge pump accumulator, and the comparator 302 is configured to operate as a thresholding circuit for firing a spike (SNN output), and the DAC 304 is configured to create an analog threshold voltage to the second input of the comparator 302. In some example embodiments, the activation module 300 may also include a mode selector 308 which couples to the input of the DAC either a threshold voltage value for the SNN operation or a control value from the SAR logic for the DNN operation.

Fig. 6 is a more detailed block diagram of an exemplary activation module 300 supporting both DNN and SNN operation according to some example embodiments. An example of a basic structure of the S&H circuit 301 is shown. The S&H circuit 301 includes two reconfigurable capacitor banks or set A and B. One terminal of each capacitor bank A and B may be connected to the ground or corresponding potential, while another terminal of each capacitor bank A and B may be connected to a switching bridge formed by switches S1, S2, S3, and S4. The switching bridge can be controlled to couple the capacitor bank A and capacitor bank B to the input of S&H circuit 301 (to receive the voltage Vmesh) or to the output of the S&H circuit 301 (and thereby to the input of the comparator 302). Further switches S5 and S6 may be provided to reset the capacitor bank A and B, respectively.

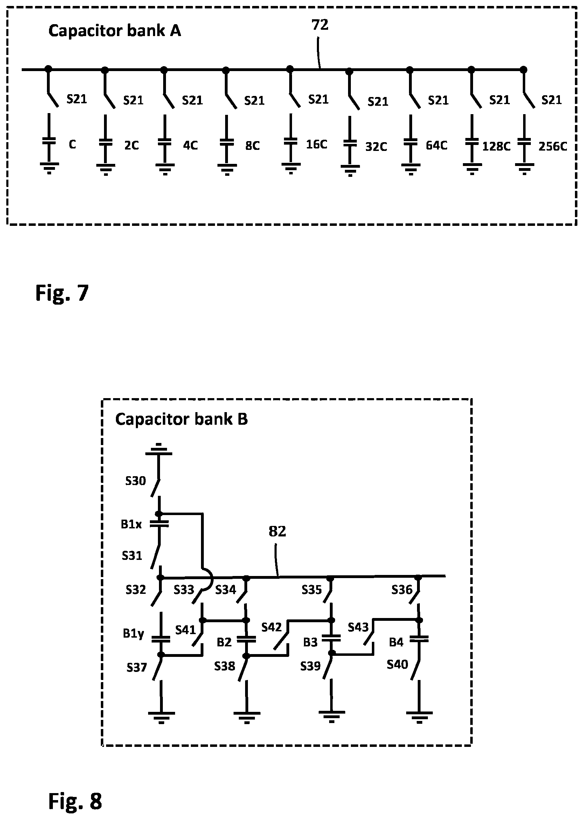

Fig. 7 is a circuit diagram of an exemplary reconfigurable capacitor bank A according to some example embodiments. In the illustrated example, the capacitor bank A is a ratioed capacitor bank with capacitors which increase by a factor 2ⁿ in capacitance value, i.e., C, 2C, 4C, 8C, ...., 256C. One terminal of each capacitor can be connected to or disconnected from a common rail 72 of the capacitor bank by a corresponding series switch S21, while other terminal of each capacitor is connected to the ground or corresponding potential. The common rail 72 forms the terminal of the capacitor bank A that is connected to the switching bridge. The overall capacitance of the capacitor bank A can be set to a desired value by selectively connecting capacitor in parallel in a suitable combination. The capacitors can be connected in parallel by closing respective switches S21.

Fig. 8 is a circuit diagram of an exemplary reconfigurable capacitor bank B according to some example embodiments. In the illustrated example, the capacitor bank B comprises number of capacitors B1x, B1y, B2, B3 and B4 of equal capacitance. The capacitor bank B further comprises number of switches S30-S43 for selectively connecting the capacitors B1x, B1y, B2, B3 and B4 in series or parallel in different combinations. One terminal of each capacitor B1x, B1y, B2, B3 and B4 can be connected to or disconnected from a common rail 82 of the capacitor bank by a respective series switch S31, S32, S34, S35, and S36, while other terminal of each capacitor is connected to the ground or corresponding potential by a respective switch S30, S37, S38, S39, and S40. Further, the capacitors B1x, B1y, B2, B3 and B4 can be selectively connected in series by further switches S33, S41, S42, and S43. The common rail 82 forms the terminal of the capacitor bank B that is connected to the switching bridge.

Referring again to Fig. 6, the exemplary DAC 304 includes a DAC controller 304A and a SAR register 304B. In embodiments, the SAR register 304B is a ratioed switched capacitor ladder with capacitors which increase by a factor 2n in capacitance value, i.e., C, 2C, 4C, 8C, ...., such as that illustrated in Fig. 6. In other embodiments, the SAR register 304B may be a switched C-2C ladder. One terminal of each capacitor is connected to a common rail, while other terminal of each capacitor can be selectively connected to either the ground or to a supply voltage by a respective switch S60. Based on a digital control input value the switches S60 are controlled to couple the capacitors to the ground and supply voltage so that a corresponding analog output voltage is formed on the common rail 62. The common rail 60 provides the output of the SAR register 304B which is connected to the input of the comparator 302. The control input value to the DAC controller 304A may be either a feedback control value from the SAR logic entity 306A in DNN or a threshold voltage value λ in SNN mode. A mode selector 308 may be provided to select the appropriate input to the DAC controller 304A.

Regarding the operation of the bitcell array 102 and the activation module 300 in DNN module according to some example embodiments, in DNN operation, the input buffer 108 is arranged to serially send input bits of the multibit input to the bitcell array 102 one bit at a time starting with the least significant bit and ending with the most significant bit for a total of eight input cycles in the case of an 8-bit system. The bitcells 104 process the input bits in parallel. At each input cycle, each bitcell 104 multiplies the input bit with its own weight bit. Each output capacitor 206 includes a driven plate connected to the output of the multiplication unit 204 and a common plate which is effectively shared between the output capacitors 206 in the same column due to being coupled to one an-other through the MAC bit line, MAC-BL. The driven plate will be either set to the supply voltage or ground depending on the multiplication result of the individual bitcell 104, while the common plate (MAC-BL) is allowed to settle to an intermediate voltage representing the sum of the multiplication results for all the bitcells 104 in the column. The relationship between the voltage at the common plate and the ratio of high and low capacitors will be a linear function. Thus, the voltage at the common plate indicates the ratio of high to low output capacitors and, by extension, the summation of all the multiplication results. Accordingly, the binary digital multiplication result produced by the bitcells 104 in single column results in an analog voltage at the MAC bit line, MAC-BL, that represents the sum of all the multiplication results provided by the bitcells 104 in the column. The voltage at the MAC bit line, MAC-BL, will charge a holding capacitor of the capacitor mesh 112. The partial MAC result is the voltage on the MAC bit line, MAC-BL, after all of the bitcells in the column have performed the multiplication and the output capacitor has settled to a steady state. The partial MAC result is referred to as partial because it represents the summation of the multiplication results for all of the bitcells in a single column (i.e., single weight bit position) and a single input cycle (i.e., single input bit position). The capacitor mesh or ladder 11 is configured to combine of the MAC operation results of the individual column bitlines MAC-BL and to produce an analog output voltage Vmesh that represents the MAC operation result.

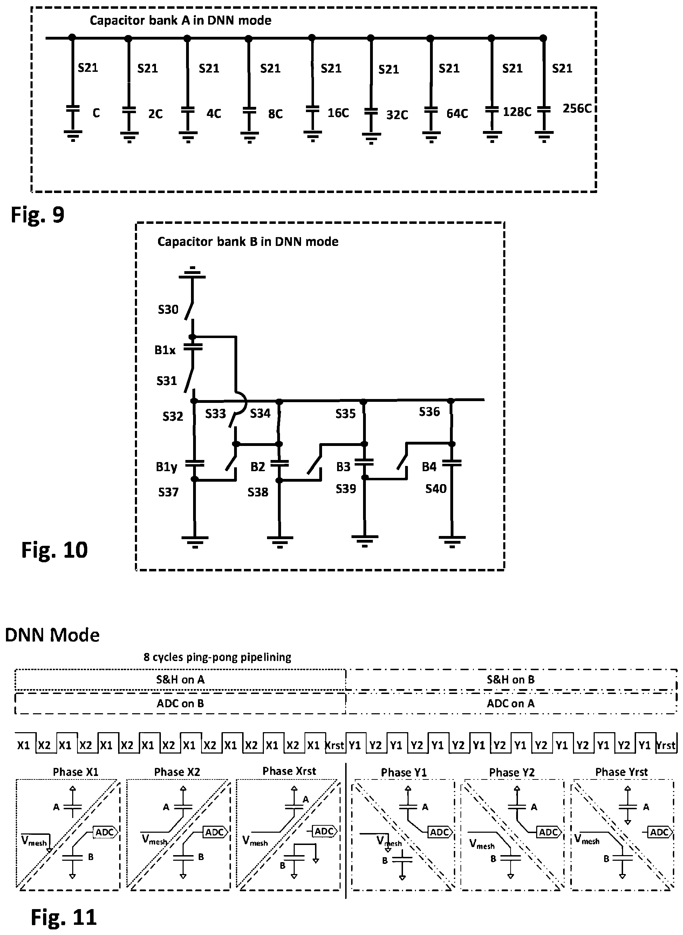

In the example, the S&H circuit 301 is configured to operate as a ping-pong buffer, and the comparator 302 in DNN mode. To that end, the reconfigurable capacitor banks A and B are configured to operate as holding capacitors that are in turn connected to the input and the output of the S&H circuit 301. The capacitances of the capacitor banks A and B are set to be equal with the total capacitance of the capacitor mesh 112, i.e., Cₘₑₛₕ = C_{A} = C_{B}. For example, the DNN configurations of the capacitor banks A and B may be as illustrated in Figs. 9 and 10, respectively.

The comparator 302, the SAR logic 306A and the DAC 304 may be configured to operate as a SAR-ADC in the DNN mode. The SAR logic 306A may control the switches S1-S4 of the S&H circuit 301 to control the ping-pong buffer operation. the SAR logic 306A also provides control values to the DAC controller 304A so that the SAR register creates the reference voltage Vref to the comparator. The output of the comparator 302 is fed back to the SAR logic 306A that changes the control value until the reference value Vref and the voltage sample are approximately equal. The digital control value of DAC controller 304 represents the value of the analog output voltage Vmesh and can be outputted as a digital DNN output from the CIM module.

Figure 11 is a diagram that illustrates an example of 8 cycles ping-pong pipelining in DNN mode according to some example embodiments. In the example, the S&H circuit 301 may have 6 different phases (state of switches S1-S6): X1, X2, Xrst, Y1, Y2, Yrst. During the first 8 cycles, the S&H circuit toggles between the phases X1 and X2, the last phase being Xrst. During the next 8 cycles, the S&H circuit toggles between the phases Y1 and Y2, the last phase being Yrst. These phase sequences are repeated. In phase X1, the capacitor bank B is connected to the SAR-ADC (to the comparator 302), the capacitor mesh 112 is reset, and capacitor bank A is unconnected. In phase X2, the capacitor bank B is connected to the SAR-ADC (to the comparator 302) and the capacitor bank A is connected to the mesh voltage Vmesh. In phase Xrst, the capacitor bank B is reset and the capacitor bank A is connected to the mesh voltage Vmesh. Thus, during the 8 cycles, the capacitor bank A is charged by the mesh voltage in 8 steps. The voltage of the capacitor bank B is measured by the SAR-ADC. In phase Y1, the capacitor bank A is connected to the SAR-ADC (to the comparator 302), the capacitor mesh 112 is reset, and capacitor bank B is unconnected. In phase Y2, the capacitor bank A is connected to the SAR-ADC (to the comparator 302) and the capacitor bank B is connected to the mesh voltage Vmesh. In phase Yrst, the capacitor bank A is reset and the capacitor bank B is connected to the mesh voltage Vmesh. Thus, during the 8 cycles, the capacitor bank B is charged by the mesh voltage in 8 steps. The voltage charged to the capacitor bank A during the previous 8 cycles is now measured by the SAR-ADC.

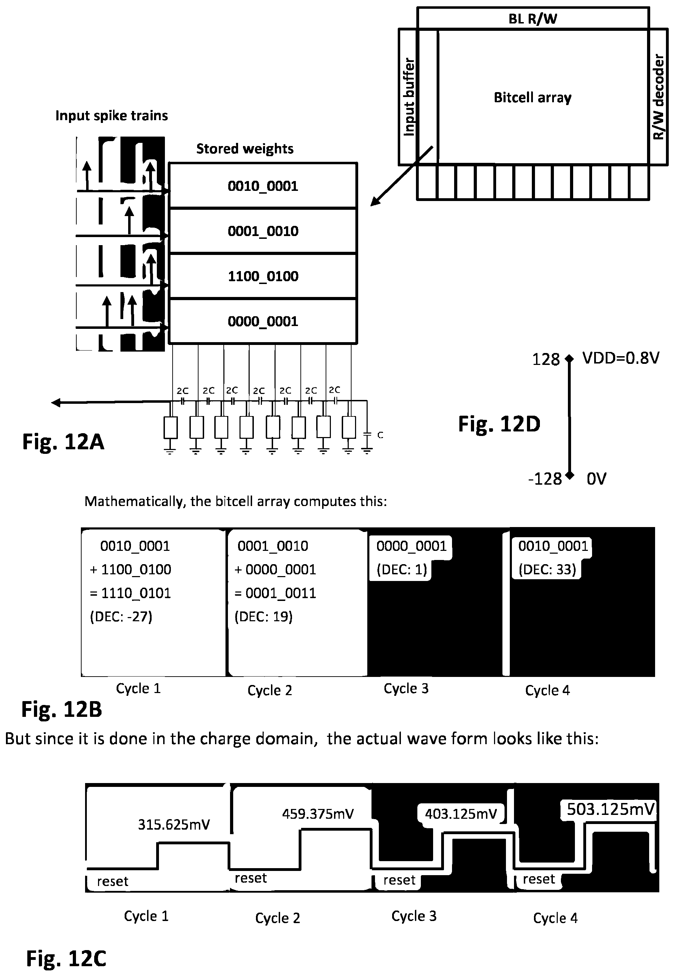

The operation of the bitcell array 102 and the activation module 300 in SNN mode in accordance with some example embodiments may be described as follows. Basically, the operation of the bit cell array 102 can be similar to the DNN, with the exception that the inputs are now spike trains. Fig. 12A is a block diagram that illustrates an example in which 4 rows with 8-bit weights in one bitcell column receive spike trains of 4 time-steps. A time-step with a spike represents a binary 1, and a time-step without a spike represents a binary 0. The spike trains are transferred to and in the bitcell array in 4 time-steps, cycles 1-4. Mathematically, the bitcell array computes cycle by cycle the digital values shown in Fig. 12B. But since the computing is done in the charge domain, the actual analog voltage waveform may be as illustrated in Fig. 12C. The relationship between the digital values and the analog voltage is shown in Fig. 12D.

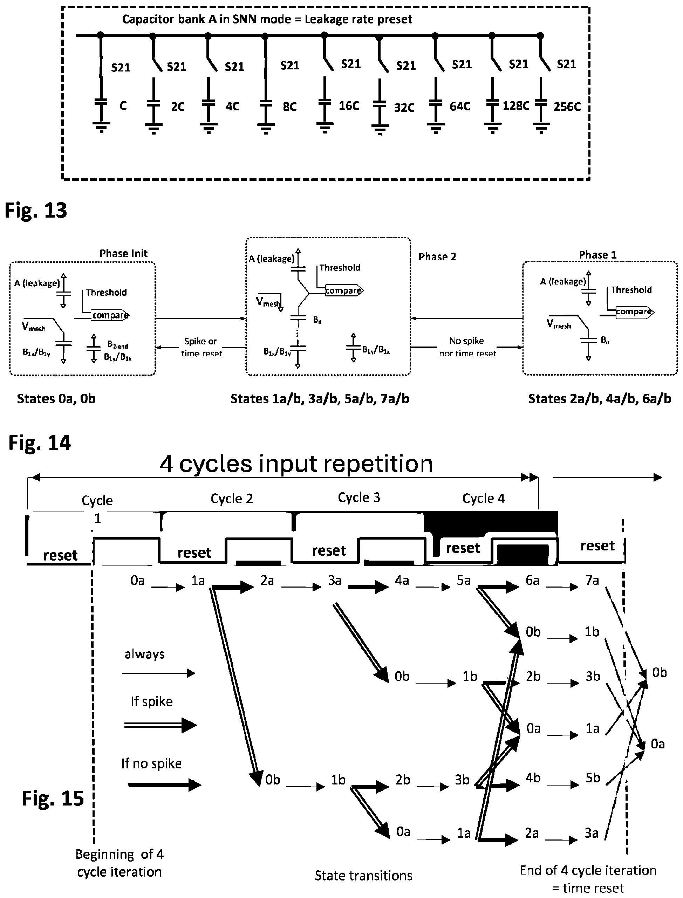

As discussed above, in the SNN mode, the S&H circuit 301 may be configured to operate as a leakage-and-charge pump accumulator, and the comparator 302 may be configured to operate as a thresholding circuit for firing a spike (SNN output), and the DAC 304 may be configured to create an analog threshold voltage to the second input of the comparator 302. In some example embodiments, the activation module 300 may be configured to implement a non-linear function called Leaky-integrate and Fire (LIF). The capacitor bank A is configured to represent the desired leakage rate. The leakage rate, also called a leak factor, is often presented by λ ∈ (0,1) or (0, 100%). Fig. 13 shows an example of the capacitor bank A configured to provide a preset leakage rate. The capacitor bank B is configured to form stacking charge pump to accumulate charges in the same bit significance. The mesh voltage Vmesh is sampled in one capacitor of the capacitor bank B at time in order B1x (or B1y), B2, B3, and B4 (generally to Bn-1, where n is the number of capacitors B). The sampled voltage of each capacitor is then stacked with previous capacitors B1x (or B1y) to B (n-1), if any, in a charge pump to perform accumulation and provide an accumulated voltage Vacc, with the capacitance bank A acting as leakage, until time reset or if the comparator 302 determines the accumulated voltage (charge) exceeds the threshold Vthresh. If the threshold Vthresh is exceeded, the activation module 300 fires an output spike. In embodiments, a ping-pong buffering is implemented for the first capacitor B1x and B1y after a time reset or firing a spike.

Fig. 13 is a block diagram illustrating three exemplary phases between which the S&H circuit 301 according to some example embodiments may change during n cycles input repetition: Phase init, Phase 1, and Phase 2. In the examples, 4 cycles input repetition is illustrated. Phase init is assumed after firing a spike or time reset in the phase 2. In the phase 2, the first capacitor B1x or B1y is charged by the mesh voltage Vmesh, and all other capacitors B2-Bn (and B1y or B1x) are reset, and the capacitor bank A is reset. Phase 2 is assumed after the phase init or after the phase 1. When the phase 2 is assumed after the phase init, the charged first capacitor B1x/B1y and the capacitor bank B are coupled to the input of the comparator 302. The capacitor mesh 112 is reset. If the accumulated voltage at the input of comparator 302 exceeds the threshold, spike is fired and the phase init is assumed again. If the accumulated voltage at the input of comparator 302 does not exceed the threshold and there is not time reset, the phase 1 is assumed. In the phase 1, the next capacitor B1-Bn is charged by the mesh voltage Vmesh, and the capacitor bank A is reset. Then the phase 2 is assumed again, and the sampled voltage of the latest capacitor is stacked with previous capacitors B1x (or B1y) to B (n-1) and connected to the input of the comparator 302 together with the capacitor bank A. Again, if the threshold is exceeded and a spike is fired, or after time reset, the phase is assumed. Otherwise, the phase 1 is assumed and the next capacitor Bn is charged. In the example, there can be operation states 0a and 0b in the phase init, operation states 1a/b, 3a/b, 5a/b, 7a/b in the phase 2, and operation states 2a/b, 4a/b, 6a/b in the phase 1.

Fig. 15 is a state diagram that illustrates an example of possible state transitions during a 4-cycle iteration (from charging the first capacitor B1x/B1y to the measuring the last accumulated voltage after 4 cycles).

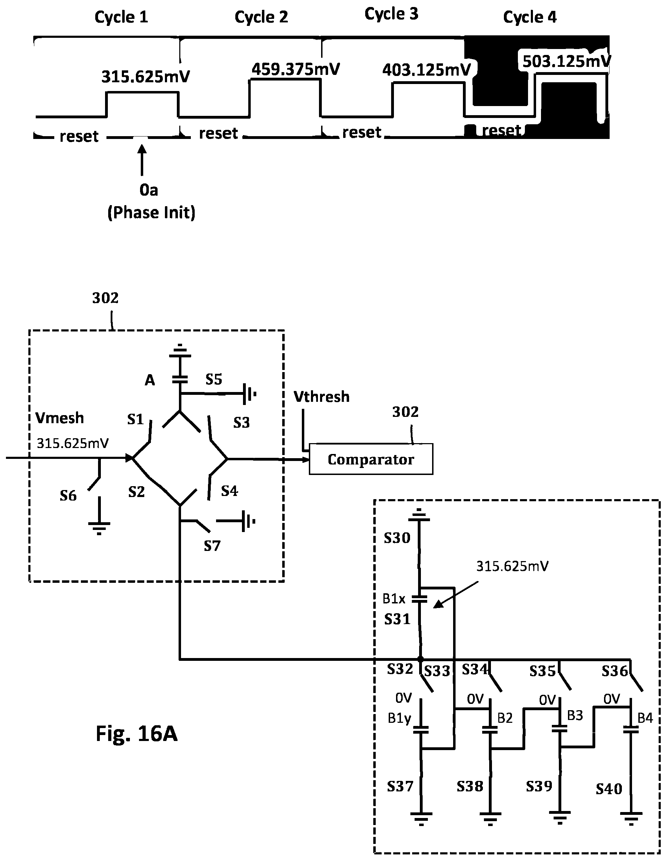

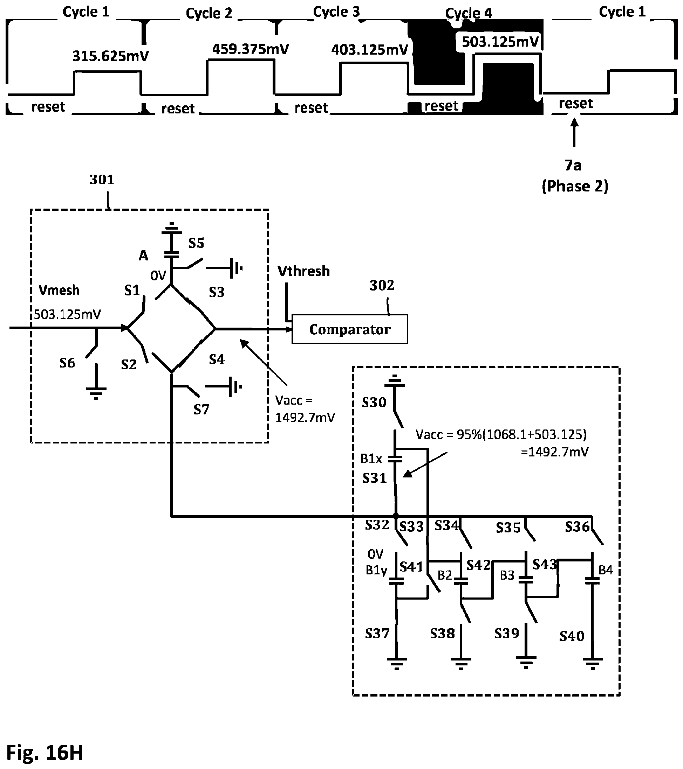

Figs. 16A-16I show circuit diagrams illustrating examples of the switch states of the switching bridge and the capacitor bank B and the related voltages during 4 iteration cycles when the spike trains are input to the bitcell array 102, computation made, and a mesh voltage waveform Vmesh is produced as presented in the example of Figs. 12A - 12D.

Fig. 16A shows the state 0a (Phase init) where the capacitor B1x is connected to the C2C ladder 112 to sample the mesh voltage Vmesh of 315.625mV, and all other capacitors of the capacitor bank B as well as the capacitor bank A are reset to 0V.

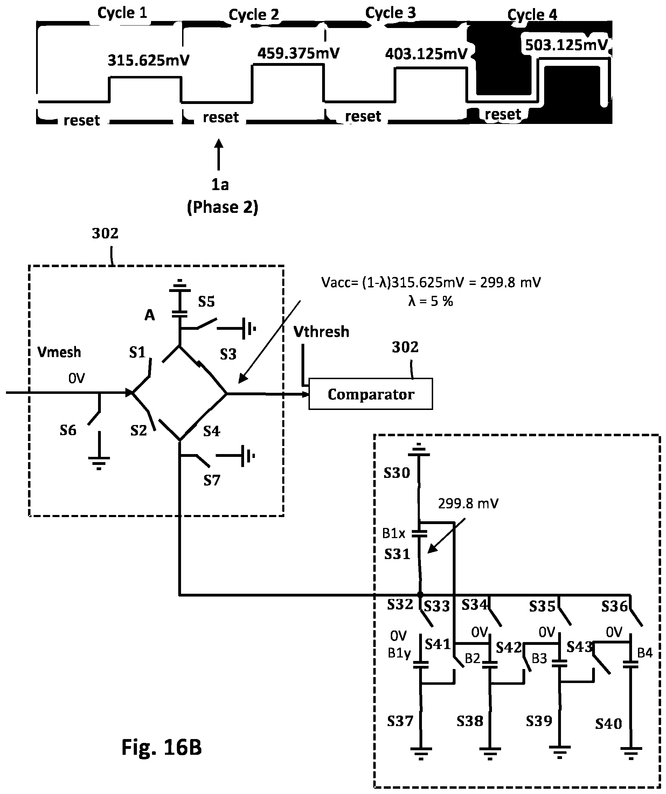

Fig. 16B shows the next state 1a (Phase 2) where the capacitor B1x and the capacitor bank A are connected to the comparator 302 on the same node, the capacitor bank A reduces the voltage Vacc on the capacitor B1x by a small amount to represent the leakage. The comparator result determines if the CIM module (neuron) fires (outputs a spike and goes to the phase init) or not (goes to the phase 1). In embodiments, the voltage Vacc is reduced by the amount λVacc. In the example, λ = 5% or λ = 0.05. In Fig. 16B, the Vacc is reduced from 315.625mV to 299.8mV.

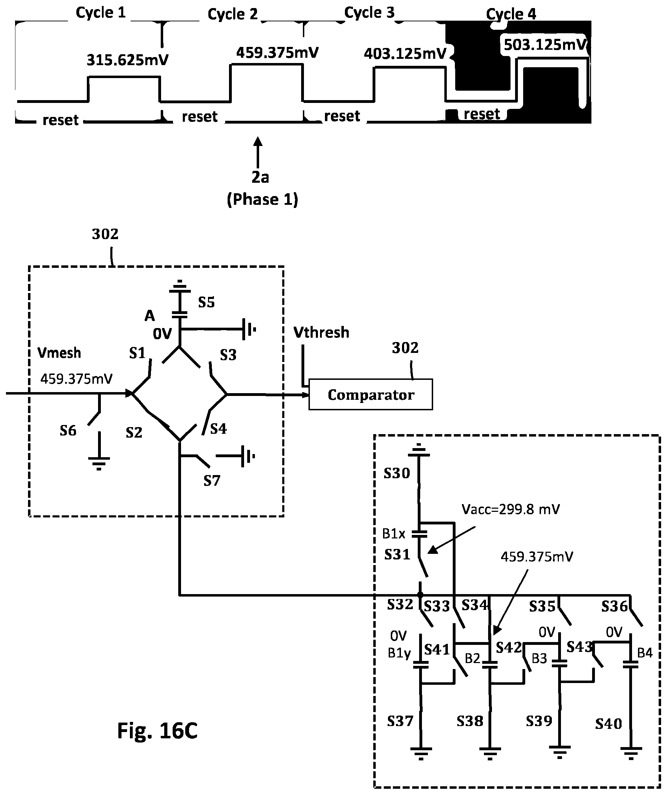

Fig. 16C shows the next state 2a (Phase 1) where the capacitor B2 is connected to the C2C ladder 112 to sample the mesh voltage Vmesh of 459.375mV, the capacitor B1x holds the previous Vacc, and the capacitor bank A are reset to 0V.

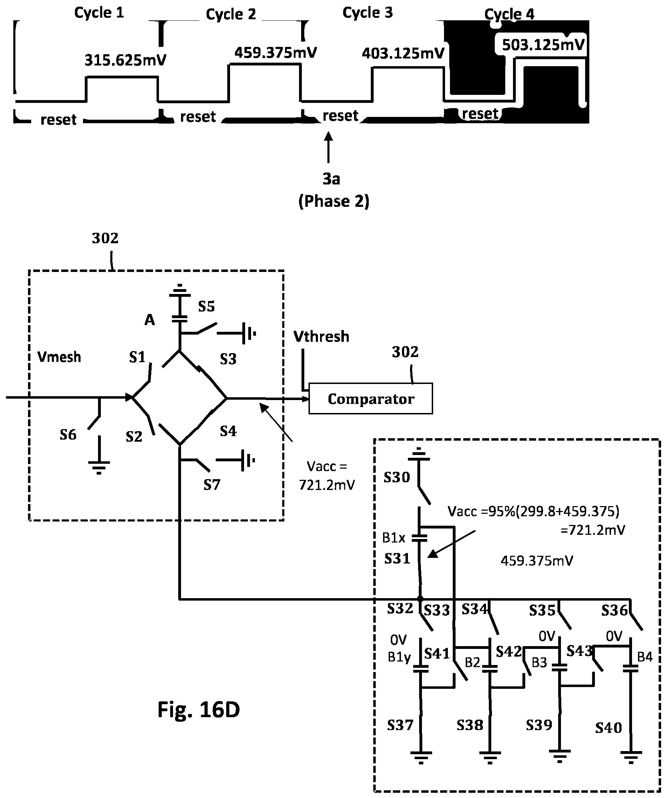

Fig. 16D shows the next state 3a (Phase 2) where the capacitor B1x stacks with the capacitor B2, their voltages combine to a stacked voltage (299.8+459.375mV), the stacked voltage and the capacitor bank A are connected to the comparator 302 on the same node, the capacitor bank A reduces the stacked voltage to 721.2mV to represent the leakage. The comparator result determines if the CIM module (neuron) fires (outputs a spike and goes to the phase init) or not (goes to the phase 1).

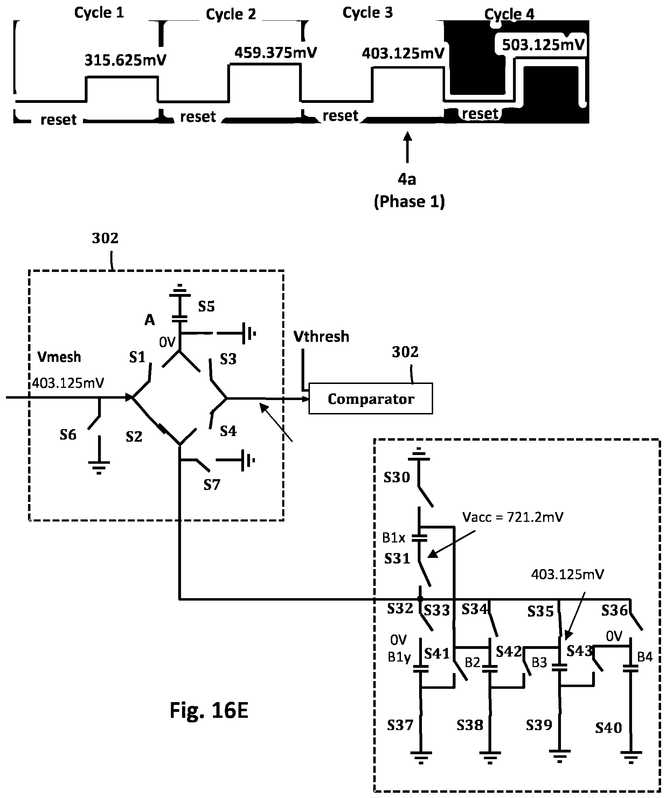

Fig. 16E shows the next state 4a (Phase 1) where all capacitors disconnect from comparator 302, the stack of B1x and B2 retains the previous voltage, B3 connects to sample the mesh voltage Vmesh of 403.125mV, the capacitor B4 remains at 0V, and the capacitance bank A resets to 0V.

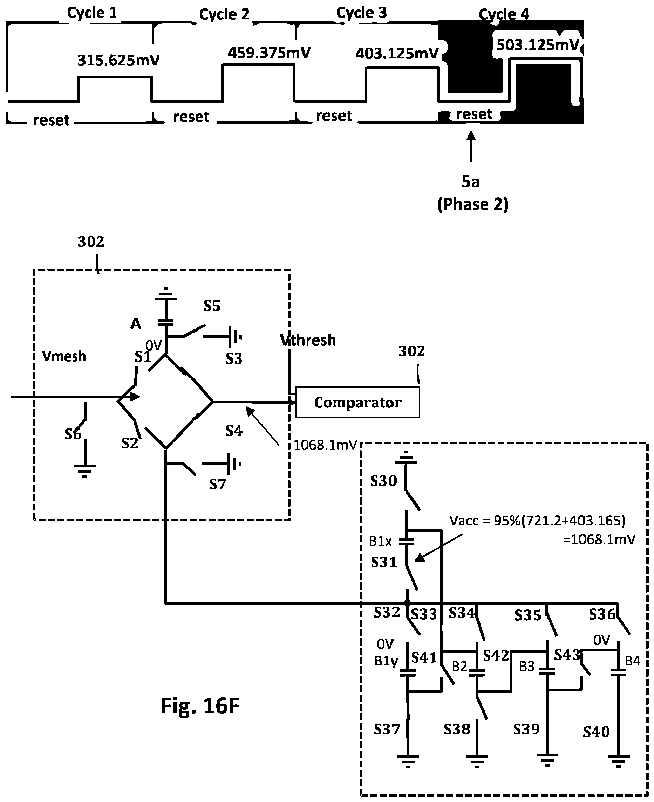

Fig. 16F shows the next state 5a (Phase 2) where the capacitors B1x-B3 are stacked, their voltages combine to a stacked voltage (721.2+403.175), the stacked voltage and the capacitor bank A are connected to the comparator 302 on the same node, the capacitor bank A reduces the stacked voltage to 1068.1mV to represent the leakage. The comparator result determines if the CIM module (neuron) fires (outputs a spike and goes to the phase init) or not (goes to the phase 1).

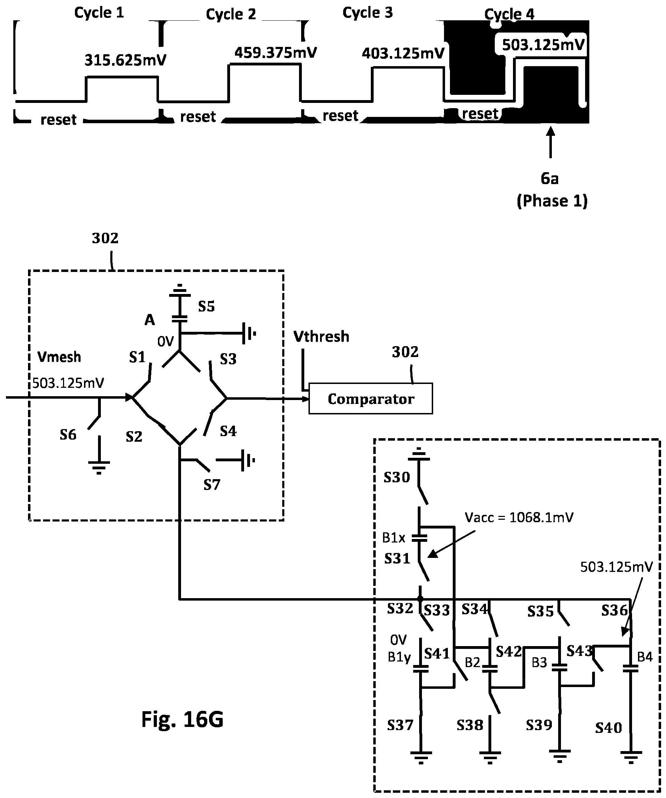

Fig. 16G shows the next state 6a (Phase 1) where all capacitors disconnect from comparator 302, the stack of B1x-B3 retains the previous voltage, B4 connects to sample the mesh voltage Vmesh of 503.125mV, and the capacitance bank A resets to 0V.

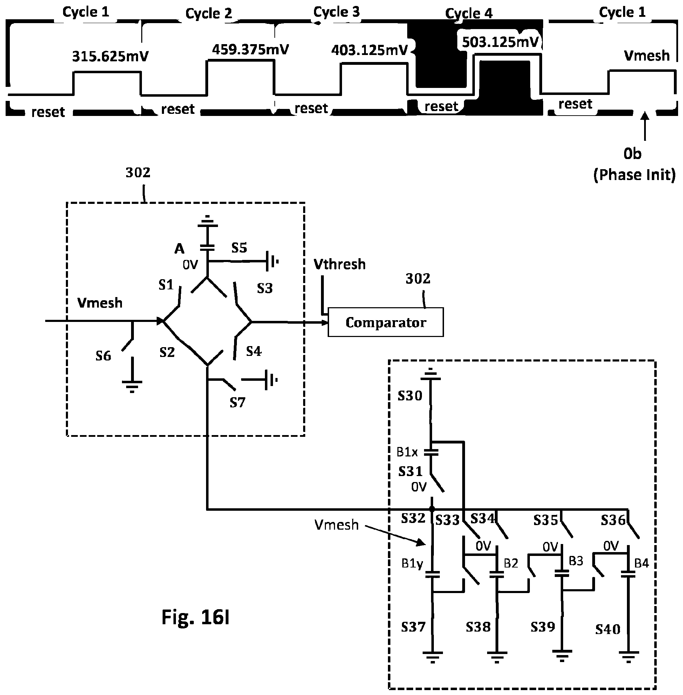

Fig. 16I shows the next state 0b (Phase init) where the capacitor B1y is connected to the C2C ladder 112 to sample the mesh voltage Vmesh, and all other capacitors of the capacitor bank B as well as the capacitor bank A are reset to 0V.

As used in this application, the terms "module" and "circuitry" may refer to one or more or all of the following: a) hardware-only circuit implementations (such as implementations in only analog and/or digital circuitry); and b) combinations of hardware circuits and software, such as (as applicable): i) a combination of analog and/or digital hardware circuit(s) with software/firmware and ii) any portions of hardware processor(s) with software (including digital signal processor(s), software, and memory(ies) that work together to cause an apparatus, such as a mobile phone, to perform various functions); and c) hardware circuit(s) and/or processor(s), such as a microprocessor(s) or a portion of a microprocessor(s), that requires software (for example firmware) for operation, but the software may not be present when it is not needed for operation.

This definition of module and circuitry applies to all uses of these terms in this application, including in any claims. As a further example, as used in this application, the term module or circuitry also covers an implementation of merely a hardware circuit or processor (or multiple processors) or portion of a hardware circuit or processor and its (or their) accompanying software and/or firmware.

The techniques and methods described herein may be implemented by various means. For example, these techniques may be implemented in hardware (one or more devices), firmware (one or more devices), software (one or more modules), or combinations thereof. For a hardware implementation, the apparatus(es) of example embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, micro-controllers, microprocessors, other electronic units designed to perform the functions described herein, or a combination thereof. For firmware or software, the implementation can be carried out through modules of at least one chipset (for example procedures, functions, and so on) that perform the functions described herein. The software codes may be stored in a memory unit and executed by processors. The memory unit may be implemented within the processor or externally to the processor. In the latter case, it can be communicatively coupled to the processor via various means, as is known in the art. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

It will be obvious to a person skilled in the art that, as technology advances, the inventive concept may be implemented in various ways within the scope of the claims. The embodiments are not limited to the example embodiments described above but may vary within the scope of the claims. Therefore, all words and expressions should be interpreted broadly, and they are intended to illustrate, not to restrict, the embodiments.

## Claims

1. An apparatus, comprising
a bit-cell array configured to generate an analog output corresponding to a multiply-accumulate (MAC) operation result using a multibit weight and a multibit input in charge domain, wherein the bitcell array comprises a plurality of bitcells connected to corresponding column bitlines via capacitive coupling, and wherein each column bitline is connected to a capacitor ladder to produce an analog output voltage that represents a combined MAC operation result of all column bitlines,
a dual-mode activation module which is selectively operable either in a Deep Neural Network (DNN) mode and a Spiking Neural Network (SNN) mode, comprising
- a sample-and-hold circuit configured to sample the analog output voltage received from the capacitor ladder to an input and hold the analog output voltage sample at an output, the sample and hold circuit comprising a first reconfigurable capacitor bank, a second reconfigurable capacitor bank, and control switch elements for selectively coupling the first reconfigurable capacitor bank and the second reconfigurable capacitor bank to the input or the output,
- a comparator having a first input to receive the analog output voltage sample, a second input, and a control output,
- a digital-to-analog converter (DAC) having a digital control input and an analog voltage output connected to the second input of the comparator, and
- a control circuitry configured to receive a comparison result from the control output of the comparator and configured to control the dual-mode activation module in accordance with the selected one of the DNN mode and the SNN mode.

2. The apparatus as claimed in claim 1, wherein in the DNN mode, the sample-and-hold circuit is configured to operate as a ping-pong buffer, the first and second reconfigurable capacitor banks are configured to operate as holding capacitors that are in turn connected to the input and the output.

3. The apparatus as claimed in any one of claims 1-2, wherein in the DNN mode, capacitances of the first and second reconfigurable capacitor banks are configured to be equal with a total capacitance of the capacitor ladder of the bitcell array.

4. The apparatus as claimed in any one of claims 1-3, wherein in the DNN mode, the comparator and the DAC are configured to operate as a successive approximation register (SAR) Analog-to-Digital converter (ADC) converting the output voltage sample into a digital output value.

5. The apparatus as claimed in any one of claims 1-4, wherein in the SNN mode, the sample-and-hold circuit is configured to operate as a leakage-and-charge pump accumulator, the second reconfigurable capacitor bank is configured to form a stacked charge pump, and the first reconfigurable capacitor bank is configured to discharge the stacked charge pump by an amount that represents a preset leakage rate.

6. The apparatus as claimed in any one of claims 1-5, wherein in the SNN mode, the comparator is configured to operate as a thresholding circuit for firing a spike.

7. The apparatus as claimed in any one of claims 1-6, wherein in the SNN mode, the DAC is configured to create an analog threshold voltage to the second input of the comparator.

8. The apparatus as claimed in any one of claims 1-7, wherein in the SNN mode, the second reconfigurable capacitor bank is configured to sample the analog output voltage in one capacitor of the second reconfigurable capacitor bank at time in a certain order, wherein the sampled voltage of each capacitor of the second reconfigurable capacitor bank is stacked with previously sampled voltage of previous capacitors, if any, to perform accumulation and provide an accumulated voltage, with the first reconfigurable capacitor bank acting as leakage, until a time reset or until the comparator determines that the accumulated voltage exceeds a threshold voltage.

9. The apparatus as claimed in any one of claims 1-8, wherein in the SNN mode, an alternating one of two preset capacitors of the second reconfigurable capacitor bank is selected as a first capacitor in order to sample the analog output voltage and to hereby provide a ping-pong buffering for the two preset capacitors after a time reset or firing a spike

10. The apparatus as claimed in any one of claims 1-9, wherein each capacitor in the first reconfigurable capacitor bank and in the second reconfigurable capacitor bank is individually connectable to and disconnectable from the respective capacitor bank to reconfigure the respective capacitor bank.

11. The apparatus as claimed in any one of claims 1-10, wherein capacitors in the second reconfigurable capacitor bank are selectively connectable in series, in parallel, and connectable to and disconnectable from the second reconfigurable capacitor bank.

12. The apparatus as claimed in any one of claims 1-11, wherein in the SNN mode, the sample-and-hold circuit is configured to sequentially, one by one, charge the capacitors in the second reconfigurable capacitor bank by the output voltage and connect the charged capacitance units in series to sequentially grow the stacked charge pump until a stacked voltage of the stacked charge pump exceeds a threshold voltage or a preset period of time expires.

13. The apparatus as claimed in any one of claims 1-12, wherein in the SNN mode, the control circuitry is configured to fire a spike responsive to the comparator determining that a threshold voltage is exceeded.

14. The apparatus as claimed in any one of claims 1-13, wherein in the SNN mode, the control circuitry is configured to reset the first and second reconfigurable capacitor banks and to restart the sequential charging of the stacked charge pump after firing a spike or after a preset period of time.

15. The apparatus as claimed in any one of claims 1-7, wherein in the SNN mode, the first reconfigurable capacitor bank is configured to discharge the stacked charge pump at a preset leakage rate or a sequence of preset leakage rates.
